# EUROPEAN PATENT APPLICATION

(11) **EP 4 807 785 A1**
(43) Date of publication of application: **16.09.2026**
(21) Application number: 24888583.2
(22) Date of filing: 28.10.2024
(51) Int. Cl.: H01L 21/308, C09K 13/06, C09K 13/08, H01L 21/304

(54) **CHEMICAL LIQUID, METHOD FOR TREATING OBJECT TO BE TREATED, AND METHOD FOR PRODUCING SEMICONDUCTOR DEVICE**

(30) Priority: 07.11.2023 JP 2023189985; 06.02.2024 JP 2024016571
(71) Applicant: FUJIFILM Corporation, Tokyo 106-8620 (JP)
(72) Inventor: TAKAHASHI, Kazutaka, Haibara-gun, Shizuoka 421-0396 (JP); TAKAHASHI, Tomonori, Haibara-gun, Shizuoka 421-0396 (JP); MIYAZAKI, Kosuke, Haibara-gun, Shizuoka 421-0396 (JP); OHTSU, Akihiko, Haibara-gun, Shizuoka 421-0396 (JP)
(74) Representative: HGF
(86) International application number: PCT/JP2024/038316
(87) International publication number: WO 2025/100286

(57) **Abstract**

The present invention provides a chemical solution that, in a case where the chemical solution is applied to a processing target containing SiGe and an Si-containing material other than SiGe, has a high etching rate ratio of SiGe to the Si-containing material and leaves little residue on the Si-containing material after application. The present invention also provides a method for processing a processing target and a method for producing a semiconductor device. The chemical solution according to an embodiment of the present invention is a chemical solution that is used for a processing target containing SiGe and an Si-containing material other than SiGe and that removes at least a part of the SiGe contained in the processing target. The chemical solution contains a polymer including a first repeating unit having at least one group selected from the group consisting of a primary amino group or a salt thereof, a secondary amino group or a salt thereof, a tertiary amino group or a salt thereof, and a quaternary ammonium group, and a second repeating unit selected from the group consisting of a repeating unit having an acid group and a repeating unit represented by -SO₂-, a fluoride ion source, and an oxidizing agent.

## Description

### BACKGROUND OF THE INVENTION

### 1. Field of the Invention

The present invention relates to a chemical solution, a method for processing a processing target, and a method for producing a semiconductor device.

### 2. Description of the Related Art

With progress in miniaturization of semiconductor devices, there has been an increasing demand to perform treatments such as etching or cleaning with high efficiency and high precision using a processing solution during a semiconductor device manufacturing process.

For example, WO2021/176913A discloses a processing solution capable of improving smoothness of a portion to be processed during etching of silicon germanium (SiGe), which contains a fluoride ion source, an oxidizing agent, and a predetermined additive.

### SUMMARY OF THE INVENTION

The inventors of the present invention applied the processing solution described in WO2021/176913A to a processing target containing SiGe and an Si-containing material other than SiGe in order to selectively dissolve SiGe; although selective dissolution of SiGe was possible, residue was likely to remain on the Si-containing material after application of the processing solution. That is, it was found that it is difficult to simultaneously achieve increasing the etching rate ratio of SiGe to the Si-containing material and reducing residue on the Si-containing material.

Accordingly, an object of the present invention is to provide a chemical solution that, in a case where the chemical solution is applied to a processing target containing SiGe and an Si-containing material other than SiGe, has a high etching rate ratio of SiGe to the Si-containing material and leaves little residue on the Si-containing material after application.

Another object is to provide a method for processing a processing target and a method for producing a semiconductor device that relate to the chemical solution.

The inventors of the present invention conducted extensive studies in order to address the above issue and consequently found that the above issue may be addressed by the following features.
[1] A chemical solution used for a processing target containing SiGe and an Si-containing material other than SiGe, the chemical solution removing at least a part of the SiGe contained in the processing target, the chemical solution containing:
   a polymer including a first repeating unit having at least one group selected from the group consisting of a primary amino group or a salt thereof, a secondary amino group or a salt thereof, a tertiary amino group or a salt thereof, and a quaternary ammonium group, and a second repeating unit selected from the group consisting of a repeating unit having an acid group and a repeating unit represented by -SO₂-;
   a fluoride ion source; and
   an oxidizing agent.
[2] The chemical solution according to [1], wherein the first repeating unit is a repeating unit having at least one group selected from the group consisting of a tertiary amino group or a salt thereof, and a quaternary ammonium group.
[3] The chemical solution according to [1] or [2], wherein the first repeating unit is a repeating unit having a quaternary ammonium group.
[4] The chemical solution according to any one of [1] to [3], wherein the acid group is a carboxylic acid group, a sulfonic acid group, or a phosphonic acid group.
[5] The chemical solution according to any one of [1] to [4], wherein the polymer has a weight-average molecular weight of 5,000 to 30,000.
[6] The chemical solution according to any one of [1] to [5], wherein the oxidizing agent is a compound selected from the group consisting of a peroxide, a perhalogen acid compound, and a nitric acid compound.
[7] The chemical solution according to any one of [1] to [6], wherein the oxidizing agent is a compound selected from the group consisting of hydrogen peroxide, peracetic acid, periodic acid or a salt thereof, and nitric acid.
[8] The chemical solution according to any one of [1] to [7], further containing an organic acid.
[9] The chemical solution according to any one of [1] to [8], further containing an inorganic acid.
[10] A method for processing a processing target, the method including contacting the chemical solution according to any one of [1] to [9] with a processing target containing SiGe and an Si-containing material other than SiGe to remove at least a part of the SiGe contained in the processing target.
[11] A method for producing a semiconductor device, the method including carrying out the method for processing a processing target according to [10].

According to the present invention, a chemical solution may be provided that, in a case where the chemical solution is applied to a processing target containing SiGe and an Si-containing material other than SiGe, has a high etching rate ratio of SiGe to the Si-containing material and leaves little residue on the Si-containing material after application.

In addition, a method for processing a processing target and a method for producing a semiconductor device that relate to the chemical solution may also be provided.

### BRIEF DESCRIPTION OF THE DRAWINGS

Fig. 1 is a cross-sectional view of a processing target of one exemplary embodiment; and
Fig. 2 is a cross-sectional view of an example of a processing target that has been processed by a method for processing a processing target according to an embodiment of the present invention.

### DESCRIPTION OF THE PREFERRED EMBODIMENTS

The present invention will be described in detail below.

The description of the constituent elements set forth below may be made on the basis of representative embodiments of the present invention. However, the present invention is not limited to such embodiments.

Hereinafter, the meanings of the descriptions in the present specification will be set forth.

In the present specification, a numerical range expressed using "to" means a range including the numerical values described before and after "to" as lower and upper limits.

The compounds described in the present specification may include structural isomers, optical isomers, and isotopes, unless otherwise specified. The structural isomers, optical isomers, and isotopes may be included alone or in combination of two or more kinds.

In the present specification, with respect to the bonding direction of a divalent group (e.g., -COO-), in a case where Y in a compound represented by "X-Y-Z" is -COO-, the compound may be either "X-O-CO-Z" or "X-CO-O-Z" unless otherwise specified.

In the present specification, "total solid content" means the total content of all the components contained in a composition other than solvents such as water and organic solvents.

In the present specification, "ppm" means "parts-per-million (10⁻⁶)", "ppb" means "parts-per-billion (10⁻⁹)", and "ppt" means "parts-per-trillion (10⁻¹²)".

In the present specification, 1 angstrom (Å) is equal to 0.1 nm.

In the present specification, "room temperature" means 25°C.

In the present specification, in a case where a molecular weight distribution is present, "molecular weight" means a weight-average molecular weight determined in terms of polyethylene glycol by gel permeation chromatography (GPC) unless otherwise specified.

The components of the chemical solution referred to in the present specification may be ionized or may form salts in the chemical solution. In a case where a component having a plurality of groups capable of forming salts, such as a polymer, is present, some of the groups capable of forming salts may form salts, or all of the groups may form salts.

### Chemical Solution

A chemical solution according to an embodiment of the present invention is a chemical solution that is used for a processing target containing SiGe and an Si-containing material other than SiGe and that removes at least a part of the SiGe contained in the processing target, the chemical solution containing the polymer described below (hereinafter also referred to as "specific polymer"), a fluoride ion source, and an oxidizing agent.

The mechanism by which the chemical solution according to the embodiment of the present invention may address the above issue of the present invention by adopting the above configuration is not necessarily clear. The inventors of the present invention presume that the specific polymer contained in the chemical solution according to the embodiment of the present invention, by containing the first and second repeating units described below, becomes more likely to adsorb on an Si-containing material other than SiGe in the processing target and more likely to be removed from the Si-containing material, thereby addressing the issue of the present invention.

The above presumption does not limit the mechanism by which the effect is obtained. In other words, even in a case where the effect is obtained by a mechanism other than the above, it is included within the scope of the present invention.

Hereinafter, in a case where the chemical solution according to the embodiment of the present invention is applied to a processing target containing SiGe and an Si-containing material other than SiGe (hereinafter also referred to simply as "processing target"), and at least one of the effect that the etching rate ratio of SiGe to the Si-containing material is high or the effect that residue is unlikely to remain on the Si-containing material after application is obtained, such a case is also referred to as a case where the effect of the present invention is excellent.

The components of the chemical solution according to the embodiment of the present invention will be described in detail below.

### Specific Polymer

The chemical solution according to the embodiment of the present invention contains a specific polymer.

The specific polymer is a polymer including a first repeating unit having at least one group selected from the group consisting of a primary amino group or a salt thereof, a secondary amino group or a salt thereof, a tertiary amino group or a salt thereof, and a quaternary ammonium group (hereinafter, such at least one group is also referred to as "specific group"), and a second repeating unit selected from the group consisting of a repeating unit having an acid group and a repeating unit represented by -SO₂-.

The first and second repeating units will be described in detail below.

### First Repeating Unit

In the first repeating unit, the primary amino group is a group represented by -NH₂, the secondary amino group is a group represented by, for example, *-NHR² (where R² represents a monovalent substituent) or *-NH-*, the tertiary amino group is a group represented by, for example, *-NR³₂ (where each R³ independently represents a monovalent substituent) or *-NR³-*, and the quaternary ammonium group is a group represented by the following Formula (A1) or (A2). The symbol * indicates a bonding site to a carbon atom.

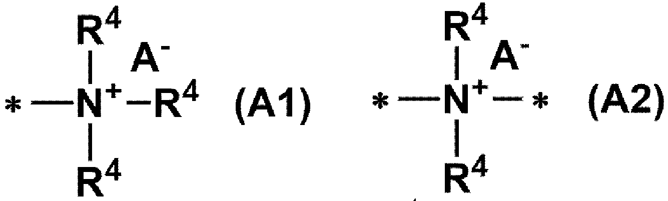

In Formulae (A1) and (A2), each R⁴ independently represents a monovalent substituent.

A⁻ represents a monovalent anion. The symbol * represents a bonding position.

The monovalent substituent represented by R² to R⁴ is not particularly limited, but is preferably a hydrocarbon group optionally having a substituent, more preferably an aliphatic hydrocarbon group having 1 to 8 carbon atoms and optionally having a substituent, further preferably an alkyl group having 1 to 4 carbon atoms and optionally having a substituent.

A plurality of R³ groups may be the same as or different from each other. A plurality of R⁴ groups may be the same as or different from each other.

Examples of A⁻ include a halogen ion (e.g., Cl⁻), a sulfate ion, a nitrate ion, an acetate ion, a methyl sulfate ion, an ethyl sulfate ion, and a hydroxide ion.

Examples of the above salt include salts formed from a primary amino group, a secondary amino group, or a tertiary amino group (hereinafter also referred to simply as "amino group"), and an acidic compound. In the specific polymer, some of the amino groups may form a salt (some of the amino groups may be free), or all of the amino groups may form a salt.

The acidic compound may be either an inorganic acid or an organic acid.

Examples of the acidic compound include hydrochloric acid, sulfuric acid, sulfurous acid, phosphoric acid, nitric acid, hydrobromic acid, sulfamic acid, acetic acid, propionic acid, methanesulfonic acid, ethanesulfonic acid, allylglycine, maleic acid, citraconic acid, fumaric acid, and itaconic acid.

The salt is preferably a hydrochloride, a hydrobromide, an acetate, a sulfate, a nitrate, a sulfite, a phosphate, a sulfamate, or a methanesulfonate, more preferably a hydrochloride, a hydrobromide, or an acetate.

From the viewpoint of further enhancing the effect of the present invention, the first repeating unit is preferably a repeating unit having at least one group selected from the group consisting of a tertiary amino group or a salt thereof and a quaternary ammonium group, more preferably a repeating unit having a quaternary ammonium group.

The number of specific groups included in the first repeating unit is not particularly limited, but is preferably 1 to 4, more preferably 1 to 3, further preferably 1 or 2.

Examples of monomers serving as a source of the first repeating unit include diallylamine, alkyldiallylamines such as methyldiallylamine, dialkyldiallylammonium salts such as dimethyldiallylammonium salts (e.g., halides, hydroxides, nitrates, and sulfates), allylamine, vinylamine, vinylpyrrolidone, acrylamide, hexadimethrine salts (e.g., halides, hydroxides, nitrates, and sulfates), 4-vinylpyridine, ornithine, lysine, arginine, histidine, and vinylimidazole. As the first repeating unit, a repeating unit composed of dimethylamine and an epihalohydrin (preferably, epichlorohydrin) may also be used.

The first repeating unit is preferably a repeating unit represented by General Formula (1-a) or a repeating unit represented by General Formula (1-b).

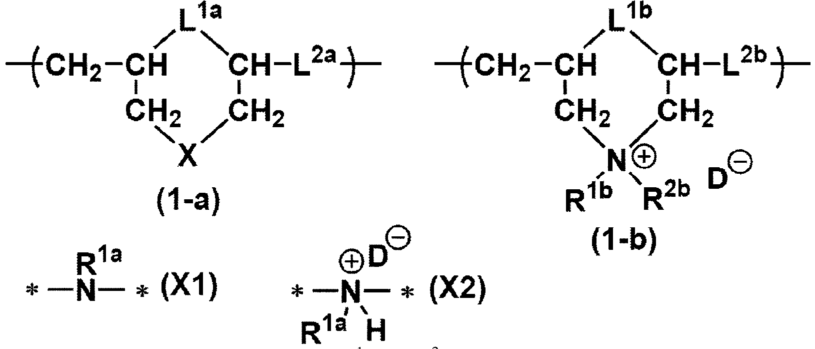

In General Formula (1-a), L^{1a} and L^{2a} each independently represent a single bond or a methylene group. In a case where L^{1a} is a single bond, L^{2a} is a methylene group, and in a case where L^{1a} is a methylene group, L^{2a} is a single bond. L^{1a} is preferably a single bond. L^{2a} is preferably a methylene group.

In General Formula (1-a), X represents a group represented by Formula (X1) or a group represented by Formula (X2). The symbol * represents a bonding position.

In Formulae (X1) and (X2), R^{1a} represents a hydrogen atom, an alkyl group having 1 to 10 carbon atoms and optionally having a hydroxy group, or an aralkyl group having 7 to 10 carbon atoms. The alkyl group having 1 to 10 carbon atoms and optionally having a hydroxy group may be linear, branched, or cyclic, and examples thereof include alkyl groups having 1 to 4 carbon atoms and optionally having a hydroxy group. Among these, a methyl group, an ethyl group, an n-propyl group, an isopropyl group, an n-butyl group, a t-butyl group, a 2-hydroxyethyl group, a 2-hydroxypropyl group, a 3-hydroxypropyl group, a 2-hydroxybutyl group, a 3-hydroxybutyl group, a 4-hydroxybutyl group, or a cyclohexyl group is preferable.

Examples of the aralkyl group having 7 to 10 carbon atoms include a benzyl group, a methylbenzyl group, a naphthylmethyl group, and a phenethyl group.

R^{1a} is preferably a hydrogen atom, a methyl group, an ethyl group, or a benzyl group.

D⁻ represents a monovalent anion.

Examples of the monovalent anion represented by D⁻ include a halide ion (e.g., a chloride ion), a sulfate ion, a nitrate ion, an acetate ion, a methyl sulfate ion, an ethyl sulfate ion, a sulfamate ion, and a hydroxide ion.

In General Formula (1-b), L^{1b} and L^{2b} each independently represent a single bond or a methylene group. In a case where L^{1b} is a single bond, L^{2b} is a methylene group, and in a case where L^{1b} is a methylene group, L^{2b} is a single bond. L^{1b} is preferably a single bond. L^{2b} is preferably a methylene group.

In General Formula (1-b), R^{1b} and R^{2b} each independently represent an alkyl group having 1 to 10 carbon atoms and optionally having a hydroxy group, or an aralkyl group having 7 to 10 carbon atoms.

Specific examples and preferable embodiments of the alkyl group having 1 to 10 carbon atoms and optionally having a hydroxy group and the aralkyl group having 7 to 10 carbon atoms are the same as those of the alkyl group having 1 to 10 carbon atoms and optionally having a hydroxy group and the aralkyl group having 7 to 10 carbon atoms represented by R^{1a}.

In General Formula (1-b), D⁻ represents a monovalent anion.

Examples of the monovalent anion represented by D⁻ include the ions exemplified as the monovalent anion represented by D⁻ in General Formula (1-a).

In General Formula (1-b), examples of the combination of R^{1b}, R^{2b}, and D⁻ include the following Examples 1 to 5. Among these, Combination 1, 5, or 6 is preferable.

In Combinations 1 to 5, the chloride ion represented by D⁻ may be replaced with an anion selected from the group consisting of a bromide ion, an iodide ion, a methyl sulfate ion, and an ethyl sulfate ion.
Example 1: R^{1b} = R^{2b} = a methyl group, D⁻ = a chloride ion
Example 2: R^{1b} = R^{2b} = an ethyl group, D⁻ = a chloride ion
Example 3: R^{1b} = R^{2b} = a propyl group, D⁻ = a chloride ion
Example 4: R^{1b} = R^{2b} = a butyl group, D⁻ = a chloride ion
Example 5: R^{1b} = an ethyl group, R^{2b} = a benzyl group, D⁻ = a chloride ion
Example 6: R^{1b} = a methyl group, R^{2b} = an ethyl group, D⁻ = an ethyl sulfate ion

The first repeating unit may also be a repeating unit represented by General Formula (1-c).

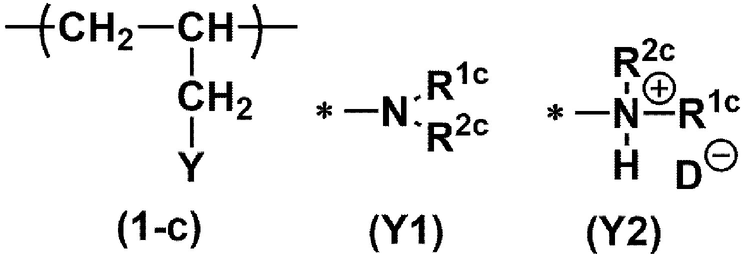

In General Formula (1-c), Y represents a group represented by Formula (Y1) or a group represented by Formula (Y2). The symbol * represents a bonding position.

R^{1c} and R^{2c} each independently represent a hydrogen atom, an alkyl group having 1 to 10 carbon atoms and optionally having a hydroxy group, or an aralkyl group having 7 to 10 carbon atoms.

Specific examples and preferable embodiments of the alkyl group having 1 to 10 carbon atoms and optionally having a hydroxy group and the aralkyl group having 7 to 10 carbon atoms are the same as those of the alkyl group having 1 to 10 carbon atoms and optionally having a hydroxy group and the aralkyl group having 7 to 10 carbon atoms represented by R^{1a}.

D⁻ represents a monovalent anion.

Examples of the monovalent anion represented by D⁻ include the ions exemplified as the monovalent anion represented by D⁻ in General Formula (1-a).

The first repeating unit may, but preferably does not, have an acid group. In a case where the repeating unit has a specific group and an acid group, the repeating unit is regarded as the first repeating unit.

The specific polymer may have only one kind of the first repeating unit, or may have two or more kinds thereof.

The content of the first repeating unit in the specific polymer is preferably 1 mol% or more, more preferably 10 mol% or more, further preferably 25 mol% or more, particularly preferably 50 mol% or more, relative to all the repeating units of the specific polymer.

The upper limit of the content of the first repeating unit is not particularly limited, but is preferably 99 mol% or less, more preferably 95 mol% or less, further preferably 90 mol% or less, particularly preferably 80 mol% or less, relative to all the repeating units of the specific polymer.

In a case where the specific polymer has two or more kinds of the first repeating unit, it is preferable that the total content thereof falls within the above range.

### Second Repeating Unit

The acid group included in the second repeating unit is not particularly limited, and examples thereof include a carboxylic acid group, a sulfonic acid group, a phosphonic acid group, and a phenolic hydroxy group. From the viewpoint of further enhancing the effect of the present invention, a carboxylic acid group, a sulfonic acid group, or a phosphonic acid group is preferable.

The number of acid groups included in the second repeating unit is not particularly limited, but is preferably 1 to 4, more preferably 1 to 3, further preferably 1 or 2.

Examples of the second repeating unit include a repeating unit represented by the following Formula (b).

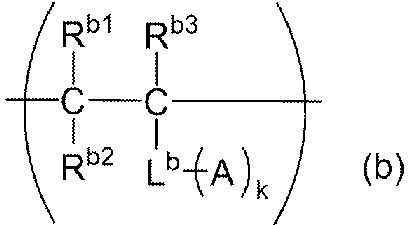

In Formula (b), R^{b1}, R^{b2}, and R^{b3} each independently represent a hydrogen atom, an alkyl group, or a functional group having an acid group.

L^{b} represents a single bond or a (k+1)-valent linking group.

A represents an acid group.

k represents an integer of 1 to 4.

In a case where a plurality of acid groups are present in Formula (b), the acid groups may be the same as or different from each other.

The alkyl group may be linear, branched, or cyclic. The number of carbon atoms of the alkyl group is preferably 1 to 12, more preferably 1 to 6, further preferably 1 to 3.

Examples of the functional group having an acid group include a group represented by - L^{b}-(A)ₖ in Formula (b). L^{b}, A, and k will be described in detail later.

R^{b1}, R^{b2}, and R^{b3} are preferably a hydrogen atom, a methyl group, an ethyl group, or a carboxyl group, and more preferably a hydrogen atom, a methyl group, or a carboxyl group.

Among these, it is preferable that one of R^{b1}, R^{b2}, and R^{b3} represents a hydrogen atom, a methyl group, or a carboxyl group, and the remaining two each represent a hydrogen atom.

The (k+1)-valent linking group represented by L^{b} is not particularly limited and may be any group having a valence corresponding to the number of A groups. Examples thereof include a divalent to pentavalent aliphatic hydrocarbon group optionally having a substituent, a divalent to pentavalent aromatic hydrocarbon group optionally having a substituent, a divalent to pentavalent aromatic heterocyclic group optionally having a substituent, -O-, -CO-, -SO₂-, - NR^{L}-, -N<, and a group formed by combining these. R^{L} represents a hydrogen atom or a monovalent organic group, and is preferably a hydrogen atom or an alkyl group having 1 to 6 carbon atoms.

In a case where k is 1, examples of the divalent linking group include a divalent aliphatic hydrocarbon group, a divalent aromatic hydrocarbon group, a divalent aromatic heterocyclic group, -O-, -CO-, -SO₂-, -NR^{L}-, and a group formed by combining these.

The divalent aliphatic hydrocarbon group is preferably an alkylene group having 1 to 6 carbon atoms (preferably having 1 to 3 carbon atoms).

L^{b} is more preferably a single bond, a methylene group, or a phenylene group.

The preferable embodiments of the acid group represented by A are as described above.

k is preferably an integer of 1 to 3, more preferably 1 or 2.

The specific polymer may have only one kind of the second repeating unit, or may have two or more kinds thereof.

The content of the second repeating unit in the specific polymer is preferably 0.1 mol% or more, more preferably 10 mol% or more, further preferably 20 mol% or more, particularly preferably 30 mol% or more, relative to all the repeating units of the specific polymer.

The upper limit of the content of the second repeating unit is not particularly limited, but is preferably 99 mol% or less, more preferably 90 mol% or less, further preferably 70 mol% or less, particularly preferably 50 mol% or less, relative to all the repeating units of the specific polymer.

In a case where the specific polymer has two or more kinds of the second repeating unit, it is preferable that the total content thereof falls within the above range.

In the specific polymer, the first and second repeating units may be bonded randomly (random copolymer), may be bonded alternately (alternating copolymer), or may be bonded in a block form (block copolymer). It is preferable that the first and second repeating units are bonded alternately or in a block form.

Among these, in a case where the second repeating unit is a repeating unit having the above acid group, it is preferable that the first repeating unit and the second repeating unit (repeating unit having an acid group) are bonded in a block form, and in a case where the second repeating unit is a repeating unit represented by -SO₂-, it is preferable that the first repeating unit and the second repeating unit (repeating unit represented by -SO₂-) are bonded alternately.

The specific polymer may have a repeating unit different from both the first and second repeating units. The content of the repeating unit different from both the first and second repeating units in the specific polymer is preferably 20 mol% or less, more preferably 0 to 10 mol%, further preferably 0 to 5 mol%, relative to all the repeating units of the specific polymer.

It is preferable that the specific polymer does not have the repeating unit different from both the first and second repeating units.

The weight-average molecular weight Mw of the specific polymer is not particularly limited, but is preferably 500 to 200,000, more preferably 800 to 100,000, further preferably 1,000 to 50,000, particularly preferably 5,000 to 30,000.

The content of the specific polymer is preferably 1 ppm to 10% by mass, more preferably 0.001% to 5% by mass, further preferably 0.01% to 3% by mass, relative to the total mass of the chemical solution.

The specific polymer may be used alone or in combination of two or more kinds. In a case where two or more kinds of the specific polymer are used, it is preferable that the total amount thereof falls within the above range.

### Fluoride Ion Source

The chemical solution according to the embodiment of the present invention contains a fluoride ion source.

The fluoride ion source is a component that releases, in the chemical solution, an ion containing a fluorine atom (an ion containing a fluorine atom, such as F⁻ and/or HF₂⁻).

Examples of the fluoride ion source include hydrofluoric acid (HF), ammonium fluoride (NH₄F), fluoroborates (e.g., KBF₄ and NH₄BF₄), fluoroboric acid, tetrabutylammonium tetrafluoroborate, hexafluoroaluminate, sodium fluoride, potassium fluoride, AlF₂, LiF₄, CaF₃, NaHF₆, NH₄HF₂, KHF₂, H₂SiF₆, and a compound represented by R^{1f}NR^{2f}R^{3f}R^{4f}F.

In R^{1f}NR^{2f}R^{3f}R^{4f}F, R^{1f}, R^{2f}, R^{3f}, and R^{4f} each independently represent a hydrogen atom or an alkyl group having 1 to 4 carbon atoms. The total number of carbon atoms of R^{1f}, R^{2f}, R^{3f}, and R^{4f} is preferably 1 to 12. Examples of the compound represented by R^{1f}NR^{2f}R^{3f}R^{4f}F include tetramethylammonium fluoride, tetraethylammonium fluoride, methyltriethylammonium fluoride, and tetrabutylammonium fluoride.

The fluoride ion source is preferably hydrofluoric acid or ammonium fluoride.

The content of the fluoride ion source is not particularly limited, but is preferably 0.001% to 10% by mass, more preferably 0.01% to 5% by mass, further preferably 0.1% to 3% by mass, relative to the total mass of the chemical solution.

The fluoride ion source may be used alone or in combination of two or more kinds. In a case where two or more kinds of the fluoride ion source are used, it is preferable that the total amount thereof falls within the above range.

### Oxidizing Agent

The chemical solution according to the embodiment of the present invention contains an oxidizing agent.

Examples of the oxidizing agent include peroxides, perhalogen acid compounds (e.g., periodic acid and salts thereof), oxidized halides (e.g., iodic acid and salts thereof), nitric acid compounds, persulfides (e.g., monopersulfides and dipersulfides), and percarbonates. From the viewpoint of further enhancing the effect of the present invention, a compound selected from the group consisting of peroxides, perhalogen acid compounds, and nitric acid compounds is preferable.

The peroxide is a compound containing one or more peroxy groups (-O-O-), and may be a peroxy acid (e.g., peracetic acid, perbenzoic acid, and salts thereof).

Other examples of the oxidizing agent include perboric acid, perborates, permanganates, cerium compounds, and ferricyanides (e.g., potassium ferricyanide).

Specific examples of the oxidizing agent include hydrogen peroxide, peracetic acid, periodic acid, potassium iodate, potassium permanganate, ammonium persulfate, ammonium molybdate, nitric acid, ferric nitrate, potassium nitrate, and a urea-hydrogen peroxide adduct.

Among these, the oxidizing agent is preferably a compound selected from the group consisting of hydrogen peroxide, peracetic acid, periodic acid and salts thereof, and nitric acid.

The content of the oxidizing agent is not particularly limited, but is preferably 0.5% by mass or more, more preferably 1% by mass or more, further preferably 5% by mass or more, relative to the total mass of the chemical solution. The upper limit of the content is preferably 30% by mass or less, more preferably 20% by mass or less, further preferably 15% by mass or less, particularly preferably less than 10% by mass, relative to the total mass of the chemical solution.

The oxidizing agent may be used alone or in combination of two or more kinds. In a case where two or more kinds of the oxidizing agent are used, it is preferable that the total amount thereof falls within the above range.

### Organic Acid or Inorganic Acid

The chemical solution according to the embodiment of the present invention preferably further contains at least one of an organic acid or an inorganic acid.

The organic acid and the inorganic acid may be at least one of a solvent or a pH adjuster in the chemical solution.

Specific examples of the organic acid and the inorganic acid include at least one acid selected from the group consisting of methanesulfonic acid, trifluoromethanesulfonic acid, oxalic acid dihydrate, citric acid, tartaric acid, picolinic acid, succinic acid, acetic acid, lactic acid, sulfosuccinic acid, benzoic acid, propionic acid, formic acid, pyruvic acid, maleic acid, malonic acid, fumaric acid, malic acid, ascorbic acid, mandelic acid, heptanoic acid, butyric acid, valeric acid, glutaric acid, phthalic acid, hypophosphorous acid, salicylic acid, 5-sulfosalicylic acid, hydrochloric acid, ethanesulfonic acid, butanesulfonic acid, p-toluenesulfonic acid, dichloroacetic acid, difluoroacetic acid, monochloroacetic acid, monofluoroacetic acid, trichloroacetic acid, trifluoroacetic acid, hydrobromic acid, sulfuric acid, and etidronic acid.

The organic acid and the inorganic acid may be salts. Examples of salts of the organic acid and the inorganic acid include ammonium acetate, sodium acetate, potassium acetate, tetraalkylammonium acetates such as tetramethylammonium acetate, phosphonium acetate, ammonium butyrate, ammonium trifluoroacetate, ammonium carbonate, ammonium chloride, ammonium sulfate, phosphoric acid, diammonium hydrogen phosphate, ammonium dihydrogen phosphate, bis(tetramethylammonium) hydrogen phosphate, disodium hydrogen phosphate, sodium dihydrogen phosphate, dipotassium hydrogen phosphate, potassium dihydrogen phosphate, ditetraalkylammonium hydrogen phosphate, ditetraalkylammonium dihydrogen phosphate, diphosphonium hydrogen phosphate, phosphonium dihydrogen phosphate, ammonium phosphonate, tetraalkylammonium phosphonate, sodium phosphonate, potassium phosphonate, and phosphonium phosphonate.

Among these, sulfuric acid or acetic acid is preferable as the organic acid or the inorganic acid.

The content of the organic acid and the inorganic acid is not particularly limited, but is preferably 0.001% to 90% by mass, more preferably 0.01% to 80% by mass, further preferably 0.1% to 70% by mass, relative to the total mass of the chemical solution.

The organic acid and the inorganic acid may be used alone or in combination of two or more kinds. In a case where two or more kinds of the organic acid and the inorganic acid are used, it is preferable that the total amount thereof falls within the above range.

### Organic Solvent

The chemical solution preferably contains an organic solvent.

Examples of the organic solvent include alcohol solvents, ketone solvents, ester solvents, ether solvents (e.g., (poly)alkylene glycols substituted at both ends with an alkyl group or an amino group), sulfone solvents, sulfoxide solvents, nitrile solvents, and amide solvents.

Examples of alcohol solvents include alkanediols (e.g., alkylene glycols), alkoxy alcohols (e.g., glycol monoethers), saturated aliphatic monohydric alcohols, unsaturated nonaromatic monohydric alcohols, and low-molecular-weight alcohols containing a ring structure.

The organic solvent is preferably one or more selected from the group consisting of acetic acid, ethylene glycol, propylene glycol, butyl diglycol, 1,4-butanediol, tripropylene glycol methyl ether, propylene glycol propyl ether, diethylene glycol n-butyl ether, hexyloxypropylamine, poly(oxyethylene)diamine, dimethyl sulfoxide, tetrahydrofurfuryl alcohol, glycerol, sulfolane, ethylene glycol monomethyl ether, ethylene glycol monoethyl ether, ethylene glycol monobutyl ether, ethylene glycol dimethyl ether, ethylene glycol diethyl ether, diethylene glycol monomethyl ether, diethylene glycol monoethyl ether, diethylene glycol monopropyl ether, diethylene glycol monoisopropyl ether, diethylene glycol monoisobutyl ether, diethylene glycol monobenzyl ether, diethylene glycol dimethyl ether, diethylene glycol diethyl ether, triethylene glycol monomethyl ether, triethylene glycol dimethyl ether, polyethylene glycol monomethyl ether, diethylene glycol methyl ethyl ether, propylene glycol monomethyl ether, propylene glycol dimethyl ether, propylene glycol monobutyl ether, monopropyl ether, dipropylene glycol monomethyl ether (DPM), dipropylene glycol monoisopropyl ether, dipropylene monobutyl ether, dipropylene glycol diisopropyl ether, 1-methoxy-2-butanol, 2-methoxy-1-butanol, 2-methoxy-2-methylbutanol, 1,1-dimethoxyethane, 2-(2-butoxyethoxy)ethanol, methanol, ethanol, isopropanol, and 1-butanol; more preferably, one or more selected from the group consisting of acetic acid, propylene glycol, and sulfolane.

The content of the organic solvent is not particularly limited, but is preferably 1% to 95% by mass, more preferably 10% to 80% by mass, further preferably 20% to 70% by mass, relative to the total mass of the chemical solution.

The organic solvent may be used alone or in combination of two or more kinds. In a case where two or more kinds of the organic solvent are used, it is preferable that the total amount thereof falls within the above range.

### Water

The chemical solution preferably contains water.

The type of water used in the chemical solution may be any type that does not adversely affect semiconductor substrates. Distilled water, deionized (DI) water, and pure water (ultrapure water) may be used. Pure water (ultrapure water) is preferable because it contains substantially no impurities and has less impact on semiconductor substrates during manufacturing of semiconductor substrates.

The content of water is preferably 0.1% by mass or more, more preferably 1% by mass or more, further preferably 10% by mass or more, relative to the total mass of the chemical solution. The upper limit of the content is preferably 99.999% by mass or less, more preferably 99.99% by mass or less, further preferably 90.0% by mass or less, relative to the total mass of the chemical solution.

### Physical Properties of Chemical Solution

### pH

The pH of the chemical solution is preferably 0.0 to 6.0, more preferably 0.1 to 4.0, further preferably 0.5 to 3.0.

The pH of the chemical solution can be measured using a known pH meter in accordance with JIS Z 8802:1984. In the present specification, the pH of the chemical solution is a value measured at room temperature (25°C) using an F-51 (trade name) manufactured by HORIBA, Ltd.

### Metal Content

The contents of metals (e.g., metal elements such as Fe, Co, Na, Cu, Mg, Mn, Li, Al, Cr, Ni, Zn, Sn, and Ag) contained as impurities in the chemical solution, as measured in terms of ion concentrations, are each preferably 5 ppm by mass or less, more preferably 1 ppm by mass or less. Among these, the content of sodium atoms in the chemical solution is preferably 1 ppm by mass or less, relative to the total mass of the chemical solution.

Since higher-purity chemical solutions are expected to be required in the manufacture of advanced semiconductor devices, it is further preferable that the content of each of the above metals is lower than 1 ppm by mass, that is, on the order of ppb or less by mass; particularly preferably 100 ppb by mass or less; most preferably less than 10 ppb by mass. The lower limit is preferably 0.

### Insoluble Particles

The chemical solution preferably does not substantially contain insoluble particles.

The term "insoluble particles" as used herein refers to particles of an inorganic solid, an organic solid, or the like that do not ultimately dissolve in the chemical solution and remain as particles therein.

The expression "does not substantially contain insoluble particles" means that, in a case where the chemical solution is diluted 10,000-fold with a solvent contained in the chemical solution to prepare a measurement composition, the number of particles having a particle size of 40 nm or more contained in 1 mL of the measurement composition is 40,000 or less. The number of particles contained in the measurement composition can be measured in a liquid phase using a commercially available particle counter.

Examples of commercially available particle counters include apparatuses manufactured by RION Co., Ltd. and Particle Measuring Systems. Representative apparatuses manufactured by RION Co., Ltd. include KS-19F. Representative apparatuses manufactured by Particle Measuring Systems include UltraChem 40. For measuring larger coarse particles, apparatuses such as the KS-42 series and the LiQuilaz II S series may be used.

Examples of the insoluble particles include particles of inorganic solids such as silica (e.g., colloidal silica and fumed silica), alumina, zirconia, ceria, titania, germania, manganese oxide, and silicon carbide; and particles of organic solids such as polystyrene, polyacrylic resins, and polyvinyl chloride.

### Coarse Particles

The chemical solution may contain coarse particles, but the content thereof is preferably low.

The term "coarse particles" as used herein refers to particles having a diameter (particle size) of 1 µm or more, assuming the particle shape to be spherical.

The coarse particles contained in the chemical solution are particles of dust, organic solids, inorganic solids, and the like contained as impurities in raw materials, and particles of dust, organic solids, inorganic solids, and the like introduced as contaminants during preparation of the chemical solution, which ultimately do not dissolve in the chemical solution and remain as particles therein.

The content of the coarse particles in the chemical solution is preferably such that the content of particles having a particle size of 1 µm or more is 100 or less, more preferably 50 or less, per 1 mL of the chemical solution. The lower limit is preferably 0 or more, more preferably 0.01 or more, per 1 mL of the chemical solution.

The content of the coarse particles present in the chemical solution can be measured in a liquid phase using a commercially available measuring apparatus employing a light-scattering liquid particle measurement method that uses a laser as a light source.

### Method for Producing Chemical Solution

The chemical solution can be produced by a known method. A method for producing the chemical solution will be described in detail below.

### Preparation Step

The chemical solution can be produced, for example, by mixing the above components.

An example of a method for preparing the chemical solution is a method in which a specific polymer, a fluoride ion source, an oxidizing agent, and an optional component as necessary are successively added to a container containing a purified solvent, followed by stirring and mixing, and adding a pH adjuster as necessary to adjust the pH of the mixed solution, thereby preparing the chemical solution. When the components are added to the container, they may be added all at once, or may be added in portions over a plurality of times.

As the stirring apparatus and the stirring method used for preparing the chemical solution, any apparatus known in the art as a stirrer or a disperser may be used. Examples of such stirrers include an industrial mixer, a portable stirrer, a mechanical stirrer, and a magnetic stirrer. Examples of such dispersers include an industrial disperser, a homogenizer, an ultrasonic disperser, and a bead mill.

### Purification

Prior to preparing the chemical solution, a purification treatment is preferably performed on one or more kinds of the raw materials used for preparing the chemical solution. A purification treatment may also be performed on the chemical solution as necessary.

The degree of purification is preferably such that purification is performed until the purity of the raw material reaches 99% by mass or more. It is more preferable that purification is performed until the purity of the stock solution reaches 99.9% by mass or more. The upper limit is preferably 99.9999% by mass or less.

Examples of purification methods include a method in which a raw material is passed through an ion-exchange resin, a reverse osmosis membrane (RO membrane), or the like, reprecipitation, distillation of a raw material, and filtering.

As the purification treatment, the above purification methods may be carried out in combination of two or more kinds. The purification treatment may be carried out a plurality of times.

### Container

The chemical solution (including a form of the diluted chemical solution described later) can be stored, transported, and used in any container that does not pose a problem in terms of corrosiveness or the like.

The container is preferably a container for semiconductor applications which has a high level of cleanliness inside the container and in which elution of impurities from the inner wall of a storage portion of the container into the chemical solution is suppressed. Examples of such containers include various containers commercially available as containers for semiconductor chemical solutions, such as the "Clean Bottle" series manufactured by Aicello Chemical Co., Ltd. and the "Pure Bottle" manufactured by Kodama Plastics Co., Ltd. The container is not limited thereto.

As the container, the containers exemplified in paragraphs [0121] to [0124] of WO2022/004217A may also be used, and the contents thereof are incorporated herein by reference.

The inside of these containers is preferably washed before filling with the chemical solution. It is preferable that the liquid used for washing has a reduced amount of metal impurities. The chemical solution may be bottled after production in containers such as gallon bottles or quart bottles and transported or stored.

In order to prevent changes in the components of the chemical solution during storage, the inside of the container may be replaced with an inert gas (e.g., nitrogen or argon) having a purity of 99.99995% by volume or more. During transportation and storage, the temperature may be normal temperature, or may be controlled within a range of -20°C to 20°C in order to prevent deterioration.

### Dilution Step

The chemical solution may be used for processing a processing target as a diluted chemical solution after being subjected to a dilution step in which a concentrated solution is diluted with a diluent such as water. That is, the chemical solution may be used after being diluted with a diluent containing water.

Each of the concentrated solution and the diluted chemical solution is also an embodiment of the chemical solution according to the present invention, provided that it satisfies the requirements of the present invention.

It is preferable that the diluent used in the dilution step is subjected to a purification treatment prior to use. It is more preferable that the diluted chemical solution obtained by the dilution step is subjected to a purification treatment.

Examples of the purification treatment include an ion component reduction treatment using an ion-exchange resin, an RO membrane, or the like and foreign matter removal by filtering, which are described above as purification treatments for the chemical solution. It is preferable to perform any one of these treatments.

The dilution ratio of the chemical solution in the dilution step may be appropriately adjusted in accordance with the type and content of each component, and the processing target that is to be processed. The ratio of the diluted chemical solution to the chemical solution before dilution (dilution factor) is preferably 10 to 10,000, more preferably 10 to 1,000, further preferably 10 to 300, in terms of mass ratio or volume ratio (volume ratio at 23°C).

The diluent preferably contains water, and more preferably is water.

The change in pH before and after dilution (the difference between the pH of the chemical solution before dilution and the pH of the diluted chemical solution) is preferably 2.0 or less, more preferably 1.8 or less, further preferably 1.5 or less.

It is preferable that the pH of the chemical solution before dilution and the pH of the diluted chemical solution each satisfy the above preferable conditions.

A specific method for the dilution step for diluting the chemical solution may be carried out in accordance with the preparation step of the chemical solution described above. As the stirring apparatus and the stirring method used in the dilution step, the known stirring apparatus described above in the preparation step of the chemical solution may also be used.

### Method for Processing Processing Target

The present invention also includes a method for processing a processing target (hereinafter also referred to simply as "the present processing method"). The present processing method is a method for processing a processing target that includes contacting the chemical solution according to the embodiment of the present invention with a processing target containing SiGe and an Si-containing material other than SiGe to remove (etch) at least a part of the SiGe contained in the processing target.

### Processing Target

SiGe is a material composed of a combination of silicon (Si) and germanium (Ge), and is preferably capable of being used as a semiconductor material.

SiGe may intentionally or inevitably contain components other than silicon and germanium. The total content of silicon and germanium in SiGe is preferably 95% to 100% by mass, more preferably 99% to 100% by mass, further preferably 99.9% to 100% by mass, relative to the total mass of SiGe.

The atomic ratio of silicon (Si) to germanium (Ge) in SiGe (the ratio of the atom% of Si atoms to the atom% of Ge atoms in SiGe, Si:Ge) is preferably 99:1 to 30:70, more preferably 95:5 to 50:50, further preferably 85:15 to 65:35.

The Si-containing material other than SiGe is not particularly limited, but is preferably at least one material selected from the group consisting of, for example, silicon, silicon oxide, silicon nitride, silicon carbide, silicon carbonitride, silicon oxycarbide, and silicon oxycarbonitride.

Specific examples of the silicon oxide include a material represented by the composition SiO_{y} (where y preferably represents 0.5 to 2.0, more preferably 1.0 to 2.0). Specific examples of the silicon oxycarbide include a material represented by the composition SiO_{z}C_{w} (where z preferably represents 0.5 to 2.0, more preferably 1.0 to 2.0, and w preferably represents 0.5 to 2.0, more preferably 1.0 to 2.0).

The materials represented by the compositions SiO_{y} and SiO_{z}C_{w} may further contain hydrogen. Examples of the material represented by the composition SiO_{z}C_{w} include Si(OC₂H₅)₄ (tetraethyl orthosilicate, TEOS).

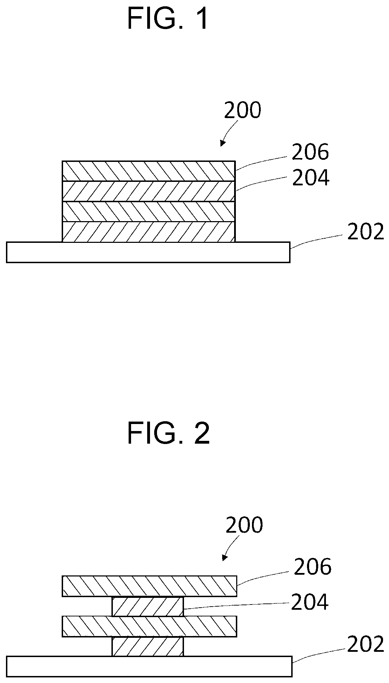

The processing target may be, for example, a processing target 200 including a substrate 202, and layers of SiGe 204 and layers of an Si-containing material 206 other than SiGe that are alternately laminated on the substrate 202, as illustrated in Fig. 1.

In Fig. 1, a configuration is shown in which the processing target 200 includes a plurality of layers of SiGe 204 and a plurality of layers of the Si-containing material 206 other than SiGe. Alternatively, one or both of the layers of SiGe 204 and the layers of the Si-containing material 206 other than SiGe may each be a single layer.

In Fig. 1, a portion of the substrate 202 is shown in which neither a layer of SiGe 204 nor a layer of the Si-containing material 206 other than SiGe is present; alternatively, such a portion may be covered with a layer of SiGe 204. In Fig. 1, a layer of SiGe 204 is disposed directly on the substrate 202; alternatively, it may be disposed with another layer interposed therebetween. The layer of the Si-containing material 206 other than SiGe may be supported by another material not shown.

The layers of the Si-containing material 206 other than SiGe may be different from each other.

The type of the substrate included in the processing target is not particularly limited, and examples thereof include various substrates such as semiconductor wafers, glass substrates for photo masks, glass substrates for liquid crystal displays, glass substrates for plasma displays, substrates for field emission displays (FEDs), substrates for optical disks, substrates for magnetic disks, and substrates for magneto-optical disks.

The size, thickness, shape, layer structure, and the like of the substrate are not particularly limited, and may be appropriately selected as desired.

Examples of wafers used as semiconductor substrates include wafers made of silicon-based materials such as silicon (Si) wafers, silicon carbide (SiC) wafers, and resin-based wafers containing silicon (glass epoxy wafers); gallium nitride (GaN); gallium phosphide (GaP) wafers; gallium arsenide (GaAs) wafers; and indium phosphide (InP) wafers.

Examples of silicon wafers include n-type silicon wafers obtained by doping silicon wafers with pentavalent atoms (e.g., phosphorus (P), arsenic (As), and antimony (Sb)); and p-type silicon wafers obtained by doping silicon wafers with trivalent atoms (e.g., boron (B) and gallium (Ga)). Examples of silicon constituting silicon wafers include amorphous silicon, single-crystal silicon, polycrystalline silicon, and polysilicon.

Among these, wafers made of silicon-based materials such as silicon wafers, silicon carbide wafers, and resin-based wafers containing silicon (glass epoxy wafers) are preferable.

The processing target may have a metal hardmask. For example, the processing target 200 shown in Fig. 1 may further have a metal hardmask.

Examples of the metal hardmask include metal hardmasks containing one or more selected from the group consisting of Cu, Co, W, AlOₓ, AlN, AlOₓN_{y}, WOₓ, Ti, TiN, ZrOₓ, HfOₓ, and TaOₓ (where x is a number of 1 to 3, and y is a number of 1 to 2).

The metal hardmask preferably contains one or more selected from the group consisting of Cu, Co, W, AlOₓ, AlN, AlOₓN_{y}, WOₓ, Ti, TiN, ZrOₓ, HfOₓ, and TaOₓ in an amount of 30% to 100% by mass, more preferably 60% to 100% by mass, further preferably 95% to 100% by mass, relative to the total mass.

The form of SiGe and the Si-containing material other than SiGe contained in the processing target is not particularly limited, and may be, for example, any of a film form, a wiring form, or a particle form. In a case where they are in film form, the thickness thereof is not particularly limited, and may be appropriately selected in accordance with the application. The thickness is, for example, 1 to 50 nm.

The SiGe and the Si-containing material other than SiGe may be disposed only on one principal surface of the substrate, or may be disposed on both principal surfaces. They may be disposed over the entire principal surface of the substrate, or may be disposed on only a part of the principal surface of the substrate.

### Processing Method

In the present processing method, the method for contacting the processing target with the chemical solution is not particularly limited, and examples thereof include a method of immersing the processing target in the chemical solution placed in a tank, a method of spraying the chemical solution onto the processing target, a method of flowing the chemical solution onto the processing target, and any combination thereof. Among these, a method of immersing the processing target in the chemical solution is preferable.

In order to further enhance the cleaning ability of the chemical solution, a mechanical stirring method may also be used.

Examples of the mechanical stirring method include a method of circulating the chemical solution over the processing target, a method of flowing or spraying the chemical solution onto the processing target, and a method of stirring the chemical solution by ultrasonic waves or megasonic waves.

The contact time between the processing target and the chemical solution may be appropriately adjusted.

The processing time (contact time between the processing target and the chemical solution) is not particularly limited, but is preferably 0.25 to 20 minutes, more preferably 0.5 to 15 minutes.

The temperature of the chemical solution during the processing is not particularly limited, but is preferably 20°C to 75°C, more preferably 20°C to 60°C.

In the present processing method, a part of the SiGe contained in the processing target may be dissolved, or all of the SiGe may be dissolved.

The processing target 200 shown in Fig. 2 is one form obtained after the processing target 200 shown in Fig. 1 is processed by the present processing method.

In the processing target 200 in this case, since the dissolution rate of the Si-containing material 206 other than SiGe is sufficiently low compared with that of SiGe, a part of the layers of SiGe 204 is dissolved from the side surface to form a concave section.

The present processing method may further include, as necessary, a rinsing step of rinsing the processing target using a rinse liquid.

For example, after bringing the processing target into contact with the chemical solution, the rinsing step may be further carried out.

Preferred examples of the rinse liquid include water; hydrofluoric acid (preferably 0.001 to 1 mass% hydrofluoric acid); hydrochloric acid (preferably 0.001 to 1 mass% hydrochloric acid); hydrogen peroxide (preferably 0.5 to 31 mass% hydrogen peroxide, more preferably 3 to 15 mass% hydrogen peroxide); a mixed solution of hydrofluoric acid and hydrogen peroxide (FPM); a mixed solution of sulfuric acid and hydrogen peroxide (SPM); a mixed solution of aqueous ammonia and hydrogen peroxide (APM); a mixed solution of ammonium hydroxide, hydrogen peroxide, and water (SC-1); a mixed solution of hydrochloric acid and hydrogen peroxide (HPM); carbon dioxide-dissolved water (preferably 10 to 60 mass ppm carbon dioxide-dissolved water); ozonated water (preferably 10 to 60 mass ppm ozonated water); hydrogen-dissolved water (preferably 10 to 20 mass ppm hydrogen-dissolved water); an aqueous citric acid solution (preferably 0.01 to 10 mass% aqueous citric acid solution); sulfuric acid (preferably 1 to 10 mass% aqueous sulfuric acid solution); aqueous ammonia (preferably 0.01 to 10 mass% aqueous ammonia); isopropyl alcohol (IPA); an aqueous hypochlorous acid solution (preferably 1 to 10 mass% aqueous hypochlorous acid solution); aqua regia (preferably aqua regia corresponding to a formulation having a volume ratio of 2.6:1.4 to 3.4:0.6 in terms of 37 mass% hydrochloric acid:60 mass% nitric acid); ultrapure water; nitric acid (preferably 0.001 to 1 mass% nitric acid); perchloric acid (preferably 0.001 to 1 mass% perchloric acid); an aqueous oxalic acid solution (preferably 0.01 to 10 mass% aqueous oxalic acid solution); acetic acid (preferably 0.01 to 10 mass% aqueous acetic acid solution, or glacial acetic acid); and an aqueous periodic acid solution (preferably 0.5 to 10 mass% aqueous periodic acid solution, examples of periodic acid include orthoperiodic acid and metaperiodic acid).

The terms "hydrofluoric acid", "nitric acid", "perchloric acid", and "hydrochloric acid" as used herein refer to aqueous solutions containing HF, HNO₃, HClO₄, and HCl dissolved in water, respectively.

The terms "ozonated water", "carbon dioxide-dissolved water", and "hydrogen-dissolved water" as used herein refer to aqueous solutions containing O₃, CO₂, and H₂ dissolved in water, respectively.

These rinse liquids may be used in combination without impairing the purpose of the rinsing step. The rinse liquid may contain an organic solvent.

A specific method for the rinsing step is, for example, a method of contacting the rinse liquid with the processing target.

Examples of the contacting method include a method of immersing the substrate in the rinse liquid contained in a tank, a method of spraying the rinse liquid onto the substrate, a method of flowing the rinse liquid over the substrate, and any combination thereof.

The processing time (i.e., the contact time between the rinse liquid and the processing target) is not particularly limited, and is, for example, 5 seconds to 5 minutes.

The temperature of the rinse liquid during the treatment is not particularly limited, but is, for example, generally preferably 16°C to 60°C, more preferably 18°C to 40°C. In a case where SPM is used as the rinse liquid, the temperature is preferably 16°C to 250°C. In a case where SC-1 is used as the rinse liquid, the temperature is preferably 16°C to 250°C.

The present processing method may further include, as necessary, a drying step in which a drying treatment is performed after the rinsing step. The drying method is not particularly limited, and examples thereof include spin drying, flowing of a drying gas over the substrate, heating of the substrate by heating means such as a hot plate or an infrared lamp, isopropyl alcohol (IPA) vapor drying, Marangoni drying, Rotagoni drying, and combinations thereof.

The drying time varies in accordance with the specific method used, but is usually about 30 seconds to several minutes.

### Method for Producing Semiconductor Device

The method for processing a processing target described above can be suitably applied to a method for producing a semiconductor device.

The processing method may be carried out in combination before or after other steps carried out on the substrate. The other steps may be incorporated into the cleaning method; alternatively, the processing method may be incorporated into the other steps.

Examples of the other steps include structure formation (e.g., layer formation, etching, chemical mechanical polishing, and modification) steps such as formation of metal wiring, a gate structure, a source structure, a drain structure, an insulating film, a ferromagnetic layer, and a non-magnetic layer; a resist formation step; an exposure step; a removal step; a heat treatment step; a cleaning step; and an inspection step.

The processing method may be carried out at any stage in a back-end-of-line process (BEOL), a middle-of-line process (MOL), and a front-end-of-line process (FEOL), and is preferably carried out in FEOL or MOL.

### Examples

The present invention will be described in further detail below with reference to Examples.

The materials, amounts used, ratios, processing contents, processing procedures, and the like shown in the following Examples can be appropriately modified without departing from the spirit and scope of the present invention. Accordingly, the scope of the present invention should not be construed as being limited to the following Examples.

In the preparation of each chemical solution and each evaluation described below, handling of containers, preparation of the chemical solutions, filling, storage, and analytical measurements were all carried out in a clean room satisfying ISO Class 2 or better at 23°C. Preparation of Chemical Solutions

Each chemical solution used in the tests described below was prepared by mixing the components listed in the tables below (fluoride ion source, oxidizing agent, organic solvent, additive, water, and specific polymer) so that the content of each component was the value shown in the tables. All of the components were high-purity raw materials of semiconductor grade. A purification treatment was further performed as necessary.

Unless otherwise specified, the content of each component shown in the tables is on a mass basis.

### Tests and Evaluation

The dissolution properties (etching rates, ER) of a Si-containing material and SiGe and residue (contact angle) on the Si-containing material were evaluated for each chemical solution in accordance with the procedures described below.

### Dissolution Property

A substrate on which silicon germanium (Si:Ge = 75:25 (atomic ratio)) film was formed to a thickness of 50 nm and a substrate on which silicon oxycarbonitride (SiOCN) film was formed to a thickness of 100 nm were prepared. These substrates were each cut into 2 × 2 cm squares to prepare test specimens.

Each test specimen was immersed in a chemical solution (25°C) of an Example or Comparative Example for 2 minutes.

Before and after the immersion test, the thicknesses of the SiGe film and the SiOCN film were measured using an optical film thickness meter, Ellipsometer M-2000 (manufactured by J.A. Woollam Co.). For each chemical solution, the dissolution rates (Å/min) of the films were calculated from the film thicknesses measured before and after immersion.

The dissolution properties of each chemical solution with respect to the films were evaluated on the basis of the calculated dissolution rates of the films in accordance with the evaluation criteria shown below. In each evaluation criterion, the closer the rating is to A, the better the evaluation.

### Evaluation Criteria for Dissolution Property with Respect to SiGe Film

A: dissolution rate of 30 Å/min or more
B: dissolution rate of 5 Å/min or more and less than 30 Å/min
C: dissolution rate of less than 5 Å/min

### Evaluation Criteria for Dissolution Property with Respect to SiOCN Film

A: dissolution rate of less than 0.1 Å/min
B: dissolution rate of 0.1 Å/min or more and less than 0.5 Å/min
C: dissolution rate of 0.5 Å/min or more

### Contact Angle Measurement (Evaluation of Residue on SiOCN Film)

The amount of residue on the SiOCN film was evaluated by measuring the water contact angle on the SiOCN film after the test described in <Dissolution Property> above.

The water contact angle was measured using a contact angle meter (DropMaster 701, manufactured by Kyowa Interface Science Co., Ltd.). The contact angle was measured three times on a substrate on which a SiOCN film was formed to a thickness of 100 nm 500 milliseconds after a water droplet contacted the surface, and the average value was taken as the contact angle (°). In the analysis, the surface tension of water was taken as 72.9 mN/m, and the measurements were carried out at 23°C.

The amount of residue on the SiOCN film was evaluated on the basis of the water contact angle in accordance with the following evaluation criteria. The closer the rating is to A, the smaller the amount of residue on the SiOCN film, and the better the evaluation.

### Evaluation Criteria for Water Contact Angle on SiOCN Film

A: contact angle of 10° or more and less than 35°
B: contact angle of 35° or more and less than 45°
C: contact angle of 45° or more

### Results

Tables 1 and 2 show the formulations of the chemical solutions used in the above tests and the evaluation results.

In Tables 1 and 2, the content of each component is on a mass basis.

In the columns "Evaluation Results" in Tables 1 and 2, the measured values in each test are shown in the upper rows, and the evaluations corresponding to the measured values are shown in the lower rows.

**[Table 1]**

| Table 1 | Name | Structure | Example 1 | Example 2 | Example 3 |
|---|---|---|---|---|---|
| Composition | Hydrofluoric acid | HF | 0.2% | 0.2% | 0.2% |
| | Hydrogen peroxide | H₂O₂ | 8.5% | 8.5% | 8.5% |
| | Acetic acid | CH₃COOH | 69.24% | 69.24% | 69.24% |
| | Takesurf A-47-Q | | 0.01% | 0.01% | 0.01% |
| | N-(3-aminopropyl) -diethanolamine | 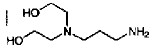 | 0.01% | 0.01% | 0.01% |
| | Sulfuric acid | H₂SO₄ | 0.9% | 0.9% | 0.9% |
| | Water | H₂O | 21.10% | 21.10% | 21.10% |
| | P(DADMAC/MA) | 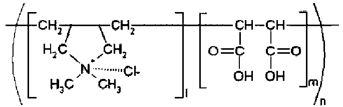 | 0.04% | - | - |
| | P(DAMA/MA) | 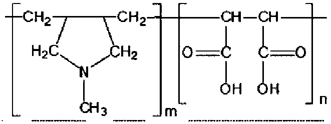 | - | 0.04% | - |
| | P(AA/MA) | | - | - | 0.04% |
| | PDADMAC | 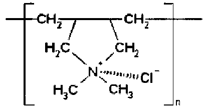 | - | - | - |
| | PDAMA | 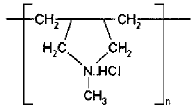 | - | - | - |
| | PAA | 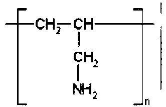 | - | - | - |
| | Total | | 100.00% | 99.96% | 99.96% |
| Evaluation results | SiGe 25% ER [Å/min.] | | 94 | 92 | 36 |
| | | | A | A | A |
| | SiOCN ER [Å/min.] | | 0.05 | 0.49 | < 0.05 |
| | | | A | B | A |
| | Water contact angle | | 32.9° | 22.9° | 22.9° |
| | | | A | A | A |

**[Table 2]**

| Table 1 (continued) | Name | Comparative example 1 | Comparative example 2 | Comparative example 3 | Comparative example 4 |
|---|---|---|---|---|---|
| Composition | Hydrofluoric acid | 0.2% | 0.2% | 0.2% | 0.2% |
| | Hydrogen peroxide | 8.5% | 8.5% | 8.5% | 8.5% |
| | Acetic acid | 69.24% | 69.24% | 69.24% | 69.24% |
| | Takesurf A-47-Q | 0.01% | 0.01% | 0.01% | 0.01% |
| | N-(3-aminopropyl) -diethanolamine | 0.01% | 0.01% | 0.01% | 0.01% |
| | Sulfuric acid | 0.9% | 0.9% | 0.9% | 0.9% |
| | Water | 21.14% | 21.10% | 21.10% | 21.10% |
| | P(DADMAC/MA) | - | - | - | - |
| | P(DAMA/MA) | - | - | - | - |
| | P(AA/MA) | - | - | - | - |
| | PDADMAC | - | 0.04% | - | - |
| | PDAMA | - | - | 0.04% | - |
| | PAA | - | - | - | 0.04% |
| | | 100.00% | 99.96% | 99.96% | 99.96% |
| Evaluation results | SiGe 25% ER [Å/min.] | 121 | 83 | 96 | 108 |
| | | A | A | A | A |
| | SiOCN ER [Å/min.] | 0.77 | < 0.05 | < 0.05 | 0.92 |
| | | C | A | A | C |
| | Water contact angle | 32.6° | 54.3° | 50.0° | 27.5° |
| | | A | C | C | A |

**[Table 3]**

| Table 2 | Name | Structure | Example 4 | Example 5 |
|---|---|---|---|---|
| Composition | Hydrofluoric acid | HF | 0.2% | 0.2% |
| | Hydrogen peroxide | H₂O₂ | 8.5% | 8.5% |
| | Acetic acid | CH₃COOH | 69.24% | 69.24% |
| | Takesurf A-47-Q | | 0.01% | 0.01% |
| | Sulfuric acid | H₂SO₄ | 0.9% | 0.9% |
| | Water | H₂O | 21.11% | 21.11% |
| | P(DADMAE/SD) | 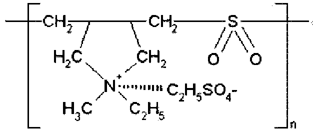 | 0.04% | - |
| | P(DADMAE/MA) | 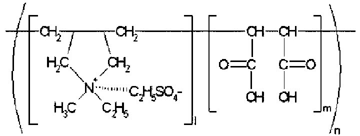 | - | 0.04% |
| | Total | | 100.00% | 100.00% |
| Evaluation results | SiGe 25% ER [Å/min.] | | 88 | 91 |
| | | | A | A |
| | SiOCN ER [Å/min.] | | < 0.05 | < 0.05 |
| | | | A | A |
| | Water contact angle | | 36.7° | 33.1° |
| | | | B | A |

As shown in Tables 1 and 2, in a case where the chemical solution according to the embodiment of the present invention was applied to a processing target containing SiGe and an Si-containing material other than SiGe, it was confirmed that the etching rate ratio of SiGe to the Si-containing material was high and that residue was unlikely to remain on the Si-containing material after the application (Examples 1 to 5).

In contrast, in a case where the chemical solution did not contain a polymer (Comparative Example 1) or in a case where the polymer did not have the second repeating unit and was not the specific polymer (Comparative Examples 2 to 4), at least one of the effects was not satisfied.

From a comparison of Examples 1 to 3, it was also confirmed that, in a case where the first repeating unit contained in the specific polymer is a repeating unit having at least one group selected from the group consisting of a tertiary amino group or a salt thereof and a quaternary ammonium group, the etching rate of SiGe is more favorable (higher), and in a case where the first repeating unit is a repeating unit having a quaternary ammonium group, the etching rate of SiOCN is more favorable (lower).

Using a substrate on which a polysilicon (Si) film was formed to a thickness of 100 nm and a substrate on which a silicon oxide (SiO₂) film was formed to a thickness of 100 nm instead of the substrate on which an SiOCN film was formed, the dissolution properties of the Si film and the SiO₂ film were evaluated in the same manner as in <Dissolution Property> above and the amounts of residue on the Si film and the SiO₂ film (water contact angles on the Si film and the SiO₂ film) were evaluated in the same manner as in <Contact Angle Measurement (Evaluation of Residue on SiOCN Film)> above. As a result, it was confirmed that tendencies similar to those of the SiOCN film were exhibited.

Table 3 below shows the evaluation results of the dissolution rates (ER) of the SiGe film, the Si film, and the SiO₂ film, and the water contact angles on the Si film and the SiO₂ film.

The evaluation criteria for dissolution property with respect to the Si film and the evaluation criteria for dissolution property with respect to the SiO₂ film in Table 3 are shown below. In each evaluation criterion, the closer the rating is to A, the better the evaluation.

### Evaluation Criteria for Dissolution Property with Respect to Si Film

A: dissolution rate of less than 7 Å/min
B: dissolution rate of 7 Å/min or more and less than 15 Å/min
C: dissolution rate of 15 Å/min or more

### Evaluation Criteria for Dissolution Property with Respect to SiO₂ Film

A: dissolution rate of less than 2 Å/min
B: dissolution rate of 2 Å/min or more and less than 4 Å/min
C: dissolution rate of 4 Å/min or more

The evaluation criteria for water contact angle with respect to the Si film and the evaluation criteria for water contact angle with respect to the SiO₂ film in Table 3 are shown below. In each evaluation criterion, in a case where the rating is A or higher, it is considered that the amount of residue on the film is small and is at a practically acceptable level.

### Evaluation Criteria for Water Contact Angle with Respect to Si Film and SiO₂ Film

A: contact angle of 10° or more and less than 40°
B: contact angle of 40° or more

Table 3 shows the result.

**[Table 4]**

| Table 3 | | Example 1 | Example 2 | Example 3 |
|---|---|---|---|---|
| | SiGe 25% ER [Å/min.] | 94 | 92 | 36 |
| | | A | A | A |
| | Si ER [Å/min.] | 2.3 | 2.9 | 6.8 |
| Evaluation results | | A | A | A |
| | SiO₂ ER [Å/min.] | < 0.1 | 1.9 | 2.4 |
| | | A | A | B |
| | Water contact angle (Si) | A | A | A |
| | Water contact angle (SiO₂) | A | A | A |

### Reference Signs List

- 200: processing target
- 202: substrate
- 204: SiGe
- 206: Si-containing material

## Claims

1. A chemical solution used for a processing target containing SiGe and an Si-containing material other than SiGe, the chemical solution removing at least a part of the SiGe contained in the processing target,
the chemical solution comprising:
a polymer including a first repeating unit having at least one group selected from the group consisting of a primary amino group or a salt thereof, a secondary amino group or a salt thereof, a tertiary amino group or a salt thereof, and a quaternary ammonium group, and a second repeating unit selected from the group consisting of a repeating unit having an acid group and a repeating unit represented by -SO₂-;
a fluoride ion source; and
an oxidizing agent.

2. The chemical solution according to claim 1,
wherein the first repeating unit is a repeating unit having at least one group selected from the group consisting of a tertiary amino group or a salt thereof, and a quaternary ammonium group.

3. The chemical solution according to claim 1,
wherein the first repeating unit is a repeating unit having a quaternary ammonium group.

4. The chemical solution according to claim 1,
wherein the acid group is a carboxylic acid group, a sulfonic acid group, or a phosphonic acid group.

5. The chemical solution according to claim 1,
wherein the polymer has a weight-average molecular weight of 5,000 to 30,000.

6. The chemical solution according to claim 1,
wherein the oxidizing agent is a compound selected from the group consisting of a peroxide, a perhalogen acid compound, and a nitric acid compound.

7. The chemical solution according to claim 1,
wherein the oxidizing agent is a compound selected from the group consisting of hydrogen peroxide, peracetic acid, periodic acid or a salt thereof, and nitric acid.

8. The chemical solution according to claim 1,
further comprising an organic acid.

9. The chemical solution according to claim 1,
further comprising an inorganic acid.

10. A method for processing a processing target,
the method comprising contacting the chemical solution according to any one of claims 1 to 9 with a processing target containing SiGe and an Si-containing material other than SiGe to remove at least a part of the SiGe contained in the processing target.

11. A method for producing a semiconductor device,
the method comprising carrying out the method for processing a processing target according to claim 10.
